# EUROPEAN PATENT APPLICATION

(11) **EP 1 763 130 A1**
(43) Date of publication of application: **14.03.2007**
(21) Application number: 06018469.4
(22) Date of filing: 04.09.2006
(51) Int. Cl.: H03F 1/52

(54) **Protection circuit**

(30) Priority: 07.09.2005 JP 2005259761
(71) Applicant: Flying Mole Corporation, Hamamatsu-shi, Shizuoka-ken (JP)
(72) Inventor: Mizushima, Takaaki, Hamamatsu-shi Shizuoka-ken (JP); Sawai, Keisuke, Hamamatsu-shi Shizuoka-ken (JP); Ogawa, Hiroshi, Hamamatsu-shi Shizuoka-ken (JP); Yokoyama, Kenji, Tokyo (JP)
(74) Representative: Grünecker, Kinkeldey, Stockmair & Schwanhäusser Anwaltssozietät

(57) **Abstract**

A protection circuit, for protecting a protection target circuit from over-current flowing therein without stopping supply of electric power thereto, includes: a current detecting portion for detecting current flowing in the protection target circuit in form of voltage thereof; a comparing portion for comparing the voltage detected within the current detection portion, or a difference between the detected voltage and input voltage into the protection target circuit, with a reference voltage, thereby to output a comparison result; and a clipping portion for clipping input voltage direct to the protection target circuit, or voltage before being amplified to be input voltage into the protection target circuit by amplification, when the comparison result indicates that current flowing through the protection target circuit is over-current.

## Description

### BACKGROUND OF THE INVENTION

### 1. Technical Field Relating to the Invention

The present invention relates to a protection circuit applicable to an over-current protection circuit for an audio amplifier, for example.

### 2. Description of Related Art

Conventionally, such an over-current protection circuit for an audio amplifier is described in Japanese Patent Laid-Open No. 9-270652, for example. In the conventional art described in this publication, a power source supplied to a signal amplifier portion for amplifying signals to a load is turned off at the time of detecting the over-current flowing into the load such as speakers, etc., for example, thereby protecting the load from the over-current flowing therein.

However, in case of the conventional protection circuit, since the electric power source of the signal amplifier portion which amplifies the signal to the load is shut off, no signals are supplied to the load at the time of an over-current. For example, in the case of supplying audio signals to the load, an output generating sound is shut off, which therefore provides uncomfortable feeling to a listener.

Also, in cases of applying such the over-current protection circuit as mentioned above to a converter for converting A/C electric power into D/C electric power, or an inverter for inverting D/C electric power into A/C electric power, for example, when the electric power to the load becomes excessive, the supply of electric power to the load is shut off, and therefore it brings about cases where the load (for example, a processing circuit) cannot execute any processing therein.

### SUMMARY OF THE INVNETION

The present invention is accomplished by taking such the problems as mentioned above into consideration thereof, and an object thereof is to provide a protection circuit enabling protection from the over-current or the like, without stopping supply of electric power to a protection target.

According to the present invention, for accomplishing the object mentioned above, there is provided a protection circuit for at least protecting a protection target circuit from over-current, including: a current detecting portion for detecting current flowing in the protection target circuit in form of voltage thereof; a comparing portion for comparing the voltage detected within the current detection portion, or a difference between the detected voltage and input voltage into the protection target circuit, with a reference voltage, thereby to output a comparison result; and a clipping portion for clipping input voltage direct to the protection target circuit, or voltage before being amplified to be input voltage into the protection target circuit by amplification, when the comparison result indicates that current flowing through the protection target circuit is over-current.

With the protection circuit according to the present invention, the current flowing through the protection target circuit is restricted by clipping the over voltages thereof just when it is supplied into the protection target circuit, when the over-current flows in the protection target circuit. Therefore, electric power can be continuously supplied to the protection target circuit even when the over-current flows therein, and thereby enabling continuous processing within the protection target circuit.

### BRIEF DESCRIPTION OF DRAWINGS

Those and other objects, features and advantages of the present invention will become more readily apparent from the following detailed description when taken in conjunction with the accompanying drawings wherein:
Fig. 1 is a block diagram showing the structures of a protection circuit according to a first embodiment of the present invention;
Fig. 2 is a circuit diagram showing the structures of a protection circuit according to a second embodiment of the present invention;
Figs. 3A to 3H show signal waveforms at various portions within the protection circuit according to the second embodiment of the present invention;
Fig. 4 is a view explaining influences affected by the gain of an operational amplifier within the protection circuit of the second embodiment;
Fig. 5 is an explanatory view showing a characteristic within the protection circuit of the second embodiment, in particular, when the load short-circuits;
Fig. 6 is a circuit diagram showing a modified embodiment (1^{st}) of the second embodiment;
Figs 7A and 7B are views explaining a phase relationship between input/output signals of an amplifier, upon which a modified embodiment (2^{nd}) of the second embodiment make presumption; and
Fig. 8 is a circuit diagram showing the modified embodiment (2^{nd}) of the second embodiment make presumption.

### DETAILED DESCRIPTION OF THE PREFERRED EMBODIMENTS

### (A) Fist Embodiment

Hereinafter, explanation will be made on a first embodiment of the protection circuit, according to the present invention. The protection circuit of the fist embodiment is for protection of a load (such as speakers, for example) from the over-current supplied with an output of an amplifier (for example, a digital audio amplifier).

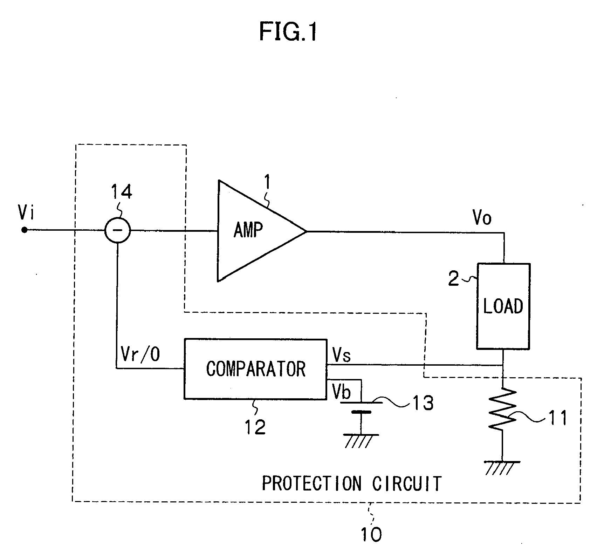

Fig. 1 is a block diagram showing the structures of the protection circuit according to the first embodiment. The protection circuit 10 of the first embodiment is provided, in relation to an amplifier 1, for supplying a voltage signal Vo obtained through amplification of an input voltage signal Vi to a load (for example, speakers) 2.

The protection circuit 10 of the first embodiment includes a detection resistor 11, a comparator portion 12, a reference voltage portion 13, and an adder portion 14.

The detection resistor 11 converts current flowing through the load 2 into voltage (i.e., detection voltage) Vs, to input it into the comparator portion 12.

The reference voltage portion 13 provides a reference voltage Vb to the comparator portion 12. This reference voltage Vb is selected to a value that can determine on whether current is the over-current or not.

The comparator portion 12 compares the detection voltage Vs and the reference voltage Vb, and when the detection voltage Vs is larger than the reference voltage Vb, it outputs difference voltage Vs-Vb, or protection voltage Vr obtained by applying a simply increasing function onto that difference voltage, while it outputs 0 when the detection voltage Vs is equal or smaller than the reference voltage Vb.

The adder portion 14 subtracts the protection voltage Vr or 0, outputted by the comparator portion 12, from the input voltage signal Vi, thereby to supply it to the amplifier 1. However, the adder portion 14 may be provided between the amplifier 1 and the load 2.

When current flowing through the load 2 is not the over-current, the detection voltage Vs obtained through voltage conversion thereof is smaller than the reference voltage Vb, therefore the comparator portion 12 outputs 0. For the reason, even if the adder portion 14 subtracts the output of the comparator portion 12 from the input voltage signal Vi, an output from the adder portion 14 remains the input voltage signal Vi as it is, and therefore each portion operates without conducting operations for over-current protection.

On the contrary, when over-current flows through the load 2, then the detection voltage Vs obtained by converting the load current into voltage comes to be larger than the reference voltage Vb, and therefore the protection voltage Vr is outputted from the comparator portion 12, depending on the difference between the detection voltage Vs and the reference voltage Vb. For that reason, the adder portion 14 subtracts the protection voltage Vr of the comparator portion 12 from the input voltage signal Vi, and inputs a voltage signal Vi-Vr after subtraction to the amplifier 1. This protects the amplifier 1 and the load 2.

Herein, the larger the input voltage signal Vi, the greater the degree of the over-current, and the detection voltage Vs is almost linear to the input voltage signal Vi. Also, the protection voltage Vr is the difference voltage Vs-Vb between the detection voltage Vs and the reference voltage Vb, or the voltage obtained by applying a simply increasing function onto the difference voltage Vs-Vb. As a result, the voltage signal Vi-Vr after the subtraction mentioned above, when over-current protection functions, has a value being almost constant. In other words, clopping the voltage portion larger than a predetermined level, with respect to such over voltage of the input voltage signal Vi, results in the voltage signal Vi-Vr after the subtraction.

According to the first embodiment, it is possible to execute the over-current protection through clipping of the input voltage signal, and also to supply the voltage signal to the load 2 continuously.

For example, even when the over-current is generated in case where the input voltage signal is the audio signal, the output for generating sounds will not be shut off, as in the conventional protection circuit, and therefore according to the first embodiment, it is possible to continue to provide the output for generating sounds while protecting it from the over-current.

### (B) Second Embodiment

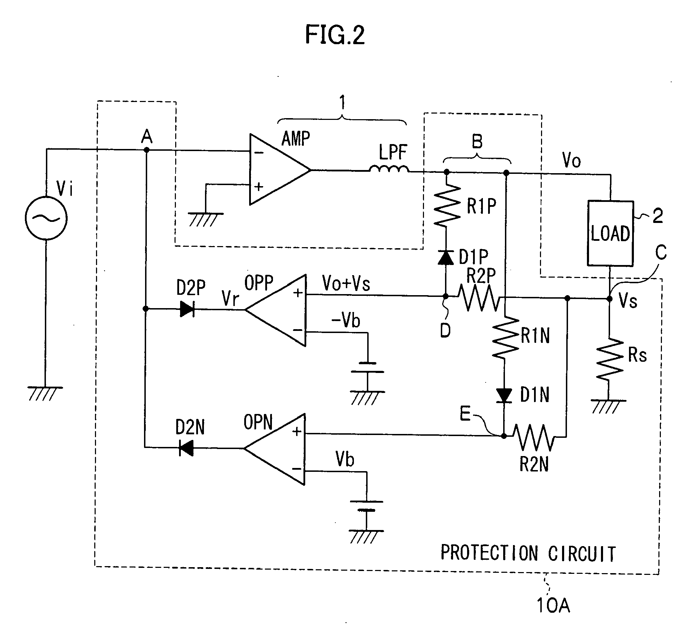

Next, explanation will be made on a second embodiment of the protection circuit according to the present invention, by referring to the drawings. The protection circuit of the second embodiment is shown in more details about the constructions thereof, comparing to that of the first embodiment. Fig. 2 is a circuit diagram showing the structures of the protection circuit according to the second embodiment.

The protection circuit 10A of the second embodiment is also provided, in relation to the amplifier 1, for supplying the voltage signal Vo obtained through amplification of the input voltage signal Vi to the load (for example, speakers) 2. However, in Fig. 2, the amplifier 1 is shown by a main body of the amplifier AMP, corresponding to a digital amplifier for audio, for example, and a low-pass filter LPF, which is provided at an output stage thereof.

The protection circuit 10A according to the second embodiment comprises a first protection circuit for functioning when the input voltage signal Vi is positive, and a second protection circuit for functioning when the input voltage signal Vi is negative. In Fig. 2, each of elements of the first protection circuit is shown by a reference numeral affixed with P at the end thereof, while each of elements of the second protection circuit by a reference numeral affixed with N at the end thereof, except for a detection resistor Rs for over-current. Thus, the second protection circuit is also similar to the first protection circuit, except for the polarity thereof.

In Fig. 1, the load 2 onto which the output voltage signal Vo from the amplifier 1 is connected to ground through the detection resistor Rs for detecting the over-current.

Between a junction point B of the low-pass filter LPF and the load 2 and a junction point C of the load 2 and the detection resistor Rs, there are connected a resistor R1P, a diode D1P (directing a cathode thereof to the side of resistor R1P), and a resistor R2P, sequentially, in that order from the junction point B. A junction point D of an anode of the diode D1P and the resistor R2P is connected to a non-reverse input terminal (i.e., a plus (+) input terminal) of the operational amplifier OPP. To a reverse input terminal (i.e., a minus (-) input terminal) of the operational amplifier OPP is connected a reference negative voltage -Vb. An output terminal of the operational amplifier OPP is connected to a cathode of the diode P2P, while an anode of this diode D2P is connected the junction point A on a route starting from a signal source to the non-reverse input terminal of the main body of amplifier AMP.

Between the junction point B of the low-pass filter LPF and the load 2 and the junction point C of the load 2 and the detection resistor Rs, there are connected a resistor R1N, a diode D1N (directing a cathode thereof to the side of resistor R1N), and a resistor R2N, sequentially, in that order from the junction point B. A junction point E of a cathode of the diode D1N and the resistor R2N is connected to a non-reverse input terminal (i.e., a plus (+) input terminal) of an operational amplifier OPN. To a reverse input terminal (i. e. , a minus (-) input terminal) of the operational amplifier OPN is connected a reference positive voltage Vb. An output terminal of the operational amplifier OPN is connected to of an anode the diode D2N, while a cathode of this diode D2N is also connected the junction point A on a route starting from the signal source to the non-reverse input terminal of the main body of amplifier AMP.

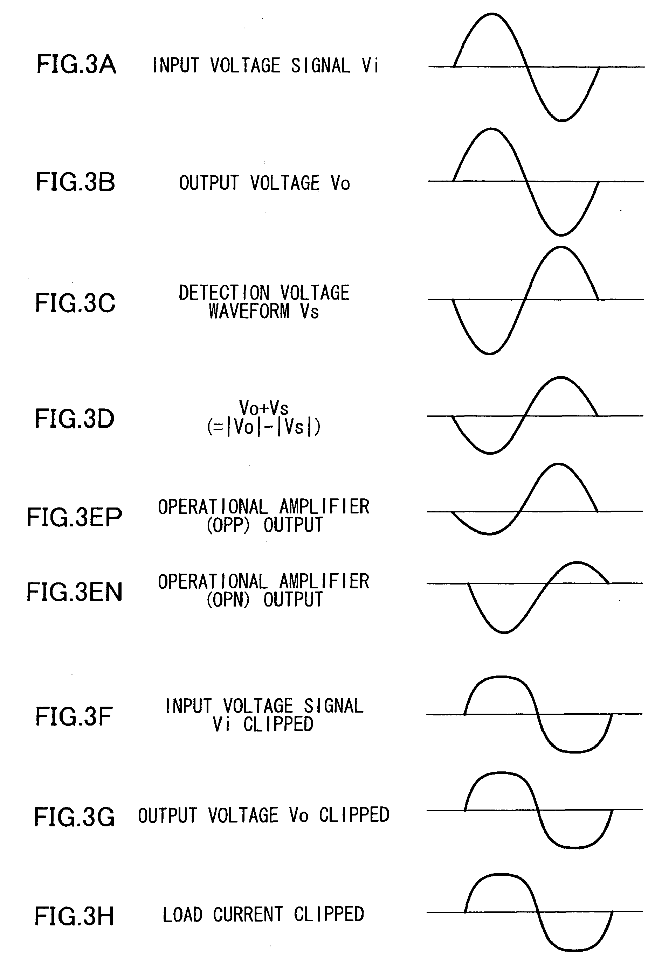

Next, explanation will be made on the operations within the protection circuit 10A having such structures as mentioned above, according to the second embodiment, by referring to signal waveforms shown in Figs. 3A to 3H.

The input voltage signal Vi from the signal-generating source shown in Fig. 3A is amplified by means of the amplifier 1, and it comes to the output voltage signal Vo to the load 2, as shown in Fig. 3B. Applying this output voltage signal Vo thereon, current flowing through the load 2 is converted into the detection voltage signal Vs, as shown in Fig. 3C, by means of the detection resistor Rs. This second embodiment is for a case where the current flowing through the load 2 is oppositely phased in a relationship to the output voltage signal Vo, and for that reason, the detection voltage signal Vs is also oppositely phased in the relationship to the output voltage signal Vo.

Since the junction point B is connected to the non-reverse input terminal of the operational amplifier OPP through the resistor R1P and the diode D1P, and the junction point C is connected to the non-reverse input terminal of the operational amplifier OPP through the resistor R2, an addition value (Vo+Vs) of the output voltage signal Vo and the detection voltage signal Vs are inputted to the non-reverse input terminal of the operational amplifier OPP. However, as mentioned above, the detection voltage signal Vs is oppositely phased in the relationship to the output voltage signal Vo and they are in such relationship, i.e., |Vo|<|Vs| under the situation where the over-current occurs. Therefore, when the output voltage signal Vo is within a positive range, the addition value (Vo+Vs) has a value |Vo|-|Vs|, as shown in Fig. 3D, i.e., a minus value.

Since the reference negative voltage (-Vb) is inputted to the reversed input terminal of the operational amplifier OPP, the output voltage of the operational amplifier OPP is Vo+Vs-(-Vb)=|Vo|-|Vs|+Vb. Under the situation where the over-current occurs, this value |Vo|-|Vs|+Vb takes a negative value, as shown in Fig. 3(EP). However, under the situation where no over-current occurs, this value |Vo|-|Vs|+Vb also takes a positive value.

When the output voltage from the operational amplifier OPP is positive, due to existence of the diode D2P, to the junction point A is transmitted no output voltage from the operational amplifier OPP.

On the other hand, since the negative output from the operational amplifier OPP is overlapped onto the positive input voltage signal Vi at the junction point A, the large value of the positive input voltage signal Vi is clipped.

In the above, the explanation is given about the operation of the first protection circuit for functioning when the input voltage signal Vi is positive. However, the second protection circuit for functioning when the input voltage signal Vi is negative performs the operations contrast to that of the first protection circuit. Fig. 3(EP) shows the output from the operational amplifier OPP, |Vo|-|Vs|-Vb, when the over-current flows, and since this is overlapped onto the negative input voltage signal Vi, therefore the negative large value of the negative input voltage signal Vi is clipped.

Fig. 3F shows the input voltage signal Vi after clipping the positive and negative large values of such input voltage signal Vi causing the over-current. Since this clipped input voltage signal Vi is inputted into the amplifier 1, the output voltage signal Vo from the amplifier 1 also comes to be clipped on the large values thereof, as shown in Fig. 3G, and the current flowing into the load 2 also comes to be clipped on the large values thereof, as shown in Fig. 3H. Thus, the over-current is suppressed, and the load 2 is protected from the over-current and/or the voltage Vo applied thereon.

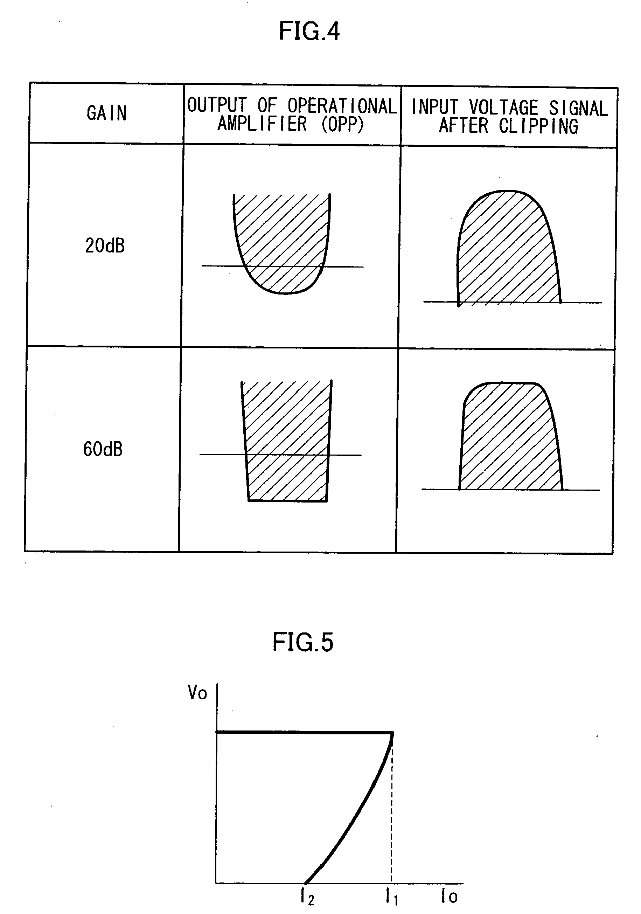

Fig. 4 shows the signal waveforms of the output voltage waveforms |Vo|-|Vs|+Vb from the operational amplifier OPP, and the input voltage signals Vi clipped, in case when the gain of the operational amplifier OPP is 20dB and 60dB, respectively. As apparent from Fig. 4, when changing the gain of the operational amplifier OPP, the roundness is changed on the output voltage waveforms |Vo|-|Vs|+Vb from the operational amplifier OPP, and an amount of pull-in into the operational amplifier is also changed, and further the roundness is also changed on the input voltage signal Vi after the clipping thereon. Thus, through selection on the gain of the operational amplifiers OPP (and OPN), it is possible to adjust the clipping function.

Also, in the protection circuit according to the second embodiment, since the input voltage into the non-reverse input terminal of the operational amplifier OPP is changed by Vs when the load 2 is short-circuited, the clipping function operates on a small value of short-circuit current. Accompanying with this, short-circuiting function further decreases, so that the condition that the clipping function works much more is repeated. Fig. 5 shows foldback current limiting characteristics between the voltage Vo applied onto the load and the load current Io, when the load is short-circuited. Making such foldback current limiting characteristics can finally suppress the short-circuited current down to I2, thereby reducing the load applied upon the amplifier when the load is short-circuited.

As mentioned above, with the second embodiment, it is possible to protect the load from the over-current, while continuing the signal input onto the load.

Also, with the second embodiment, it is possible to reduce the load of the amplifier provided at a front stage of the load, while suppressing the short-circuiting current to be small when the load is short-circuited.

### (C) Other Embodiments

The technical concept of the present invention should not be restricted only to such the structures of the embodiments as mentioned above, and the following variations of the embodiments can be listed up, which will be shown below.

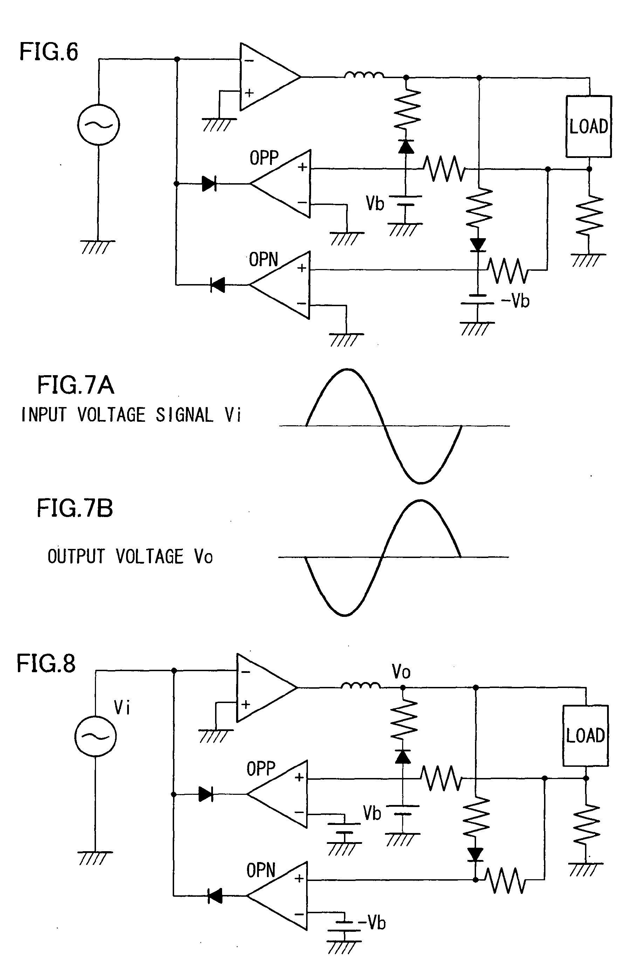

In the second embodiment, the reference voltage is inputted to the reverse input terminals of the operational amplifiers OPP and OPN. However, as shown in Fig. 6, while connecting the reverse input terminals of the operational amplifiers OPP and OPN to ground, reference voltages opposite in the polarity (i.e., positive and negative) to those in the second embodiment may be inputted to the non-reverse input terminals of the operational amplifiers OPP and OPN.

Also, in the second embodiment mentioned above, the input voltage signal Vi to the amplifier 1 and the output voltage signal Vo from the amplifier 1 are same in the phase. However, the present invention can be applied to the case where the input voltage signal Vi to the amplifier 1 and the output voltage signal Vo from the amplifier 1 are oppositely phased, as shown in Figs. 7A and 7B. Fig. 8 shows an example of the structures of the protection circuit in case of opposite phase thereof, as mentioned above, wherein the input terminals for the signals to the operational amplifiers OPP and OPN are reversed to those of the second embodiment, and also the reference voltages are reversed the polarity thereof.

In the various embodiments mentioned above, there are shown protection circuits intended to be applied to a system which supplies the audio signal (i.e., the voltage signal) from the audio amplifier to the speakers; however, the protection circuit according to the present invention may be also applied where the power source from an electric power source circuit is supplied to the load. For example, the protection circuit according to the present invention may be applied to the protection circuit, in a case where the signal generation source in Fig. 2 is the electric power source circuit and the amplifier 1 is omitted to supply the electric power to the load 2.

The present invention may be embodied in other specific forms without departing from the spirit or essential feature or characteristics thereof. The present embodiment (s) is/are therefore to be considered in all respects as illustrative and not restrictive, the scope of the invention being indicated by the appended claims rather than by the forgoing description and range of equivalency of the claims are therefore to be embraces therein.

## Claims

1. A protection circuit for at least protecting a protection target circuit from over-current, comprising:
a current detecting portion for detecting current flowing in said protection target circuit in form of voltage thereof;
a comparing portion for comparing the voltage detected within said current detection portion, or a difference between the detected voltage and input voltage into said protection target circuit, with a reference voltage, thereby to output a comparison result; and
a clipping portion for clipping input voltage direct to said protection target circuit, or voltage before being amplified to be input voltage into said protection target circuit by amplification, when the comparison result indicates that current flowing through said protection target circuit is over-current.

2. The protection circuit according to claim 1, wherein said comparing portion compares the difference between the detected voltage and the input voltage to said protection target circuit with the reference voltage, and when said protection target circuit short-circuits, said detected voltage is applied as a target to be compared with said reference voltage, while a characteristic between circuit current and input voltage is foldback current limiting characteristics when said protection target circuit short-circuits.
